# FASCICULE DE BREVET EUROPEEN

(11) **EP 0 702 454 B1**
(45) Date de publication et mention de la délivrance du brevet: **07.01.1998**
(21) Numéro de dépôt: 95410102.8
(22) Date de dépôt: 08.09.1995
(51) Int. Cl.: H03K 5/08, H04L 27/00

(54) **Détecteur du présence d'une transmission dans un modem**
Überwachungsanlage für Übertragung in einem Modem
Detector for the presence of a transmission in a modem

(30) Priorité: 14.09.1994 FR 9411211
(43) Date de publication de la demande: 20.03.1996
(73) Titulaire: SGS-THOMSON MICROELECTRONICS S.A., 94250 Gentilly (FR)
(72) Inventeur: Glass, William, 38170 Seyssinet Pariset (FR)
(74) Mandataire: de Beaumont, Michel

(56) Documents cités:
- EP-A- 0 283 299
- US-A- 5 018 190

## Description

La présente invention concerne le domaine des modulateurs/démodulateurs (modems) numériques et plus particulièrement l'opération de détection de la présence d'une transmission au sein du modem récepteur.

Dans un modem utilisant un processeur de signal, les données à transmettre sont codées sous forme numérique à partir d'un certain nombre de symboles possibles puis transmises sous forme d'échantillons de portions d'une porteuse modulée en phase et en amplitude (QAM) ou en différence de phase (DPH), puis convertis en signal analogique.

On doit pouvoir détecter, côté réception, la fin d'une transmission, ou l'interruption d'une transmission. Cette détection s'effectue sur la base de l'énergie du signal reçu. Un détecteur de transmission indique par une sortie à deux états, respectivement ON et OFF, la présence ou l'absence d'une transmission qui se caractérise par la présence ou l'absence d'une porteuse.

Chaque norme de communication fixe un seuil minimal de niveau de signal en deçà duquel la transmission doit être considérée comme interrompue. Ce seuil est par exemple de -48 dBm pour la norme V27. La norme fixe également un délai maximum pour l'identification de cette perte de transmission, par exemple de 5 à 15 ms pour la norme V27, et un seuil maximal au-delà duquel le modem doit considérer qu'une transmission est présente. Ce seuil maximal est par exemple de -43 dBm pour la norme V27. De surcroît la commutation du détecteur doit s'effectuer avec une hystérésis minimale de 2 dB. En d'autres termes, la commutation du détecteur depuis sa position OFF vers sa position ON doit intervenir à un niveau qui est d'au moins 2 dB supérieur au niveau de commutation du détecteur depuis sa position ON vers sa position OFF. L'emploi de deux seuils est lié aux ondulations que présente le signal indicateur de l'énergie du signal reçu en raison de la modulation de la porteuse.

Toutes ces contraintes conduisent à ce que le détecteur de présence d'une transmission doit à la fois commuter rapidement et être suffisamment précise.

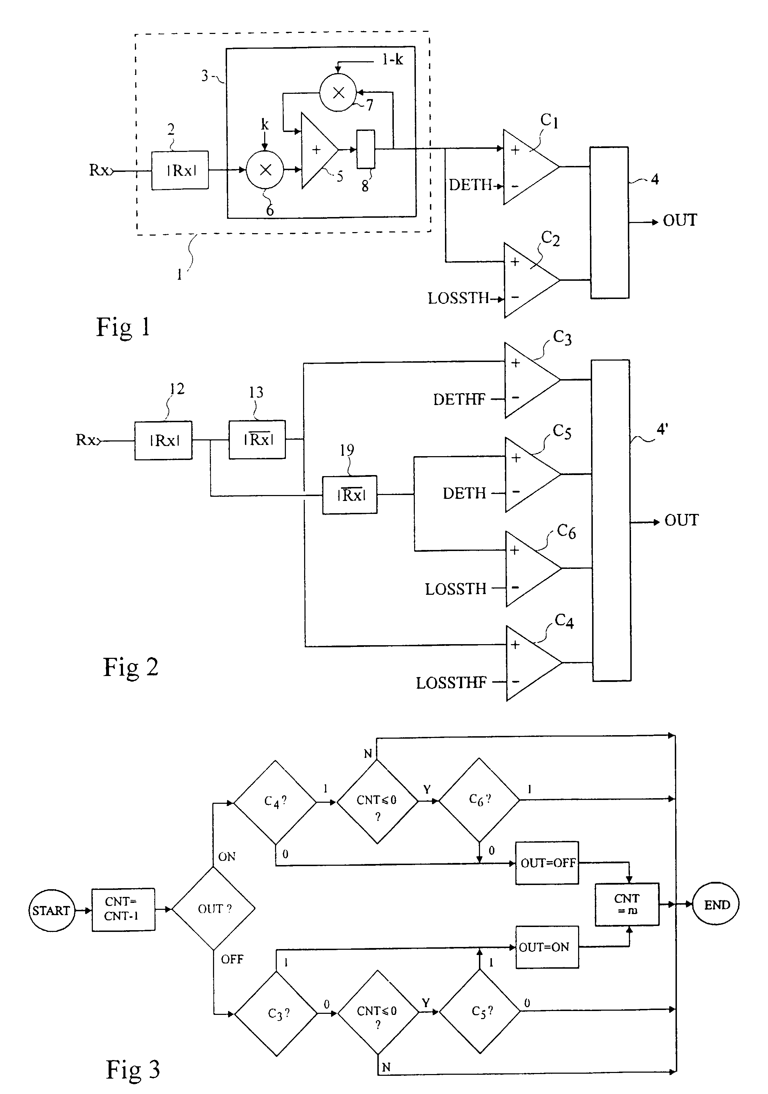

La figure 1 représente schématiquement un détecteur classique de présence d'une transmission dans un modem.

Ce détecteur comporte un calculateur d'énergie 1 comprenant un circuit de détermination de valeur absolue 2 (fournissant la valeur absolue du signal reçu Rx) dont la sortie est envoyée sur un moyenneur 3 constitué d'un filtre passe-bas récursif du premier ordre à fréquence de coupure nulle. Le signal reçu Rx par le calculateur d'énergie 1 correspond au signal reçu par le modem après numérisation. Le moyenneur 3 sert à lisser les ondulations à la sortie du circuit 2 ainsi qu'à éviter une commutation intempestive du détecteur. Deux comparateurs C1 et C2 du détecteur reçoivent chacun sur une entrée positive la sortie du moyenneur 3 qui constitue la sortie du calculateur d'énergie 1 du signal reçu Rx. Une entrée négative de chaque comparateur C1 et C2 reçoit une valeur seuil, respectivement de détection (DETH) et de perte (LOSSTH), à laquelle l'énergie du signal reçu doit être comparée. La sortie des deux comparateurs C1 et C2 est envoyée à une machine d'état 4 chargée de délivrer un signal de détection OUT à deux états (ON ou OFF) indiquant la présence ou l'absence d'une transmission. La machine d'état 4 interprète le résultat des comparaisons d'un cycle courant en utilisant, lorsque le niveau d'énergie est compris entre les deux seuils de détection DETH et de perte LOSSTH, la valeur du signal de détection OUT lors du cycle précédent pour déterminer par l'évolution du niveau s'il y a perte ou détection d'une transmission.

Un problème qui se pose dans les détecteurs classiques est que la présence nécessaire du moyenneur 3 oblige à effectuer un compromis entre le respect du délai de commutation du détecteur et la précision du détecteur.

En effet, un filtre numérique récursif passe-bas du premier ordre est constitué, comme le montre la figure 1, d'un intégrateur 5 associé à deux multiplieurs 6 et 7 et à un registre à décalage 8. Le signal devant être filtré est multiplié par un coefficient k, inférieur à 1, avant d'être envoyé sur une première entrée de l'intégrateur 5. Une seconde entrée de l'intégrateur 5 reçoit son propre signal de sortie, affecté d'un coefficient de valeur 1-k, et retardé par le registre 8. La valeur du coefficient k détermine la constante de temps du filtre mais également l'ondulation du signal de sortie du filtre.

En effet, plus le coefficient k est faible, plus la contribution de la valeur courante d'entrée est faible et plus la sortie du moyenneur 3 va être longue à atteindre la valeur d'entrée. On doit donc choisir k suffisamment grand pour respecter la contrainte de délai de commutation du détecteur (5 à 15 ms pour la norme V27).

Par contre, plus le coefficient k est élevé, plus le signal de sortie du moyenneur 3 comportera des ondulations fortes sous l'effet de la contribution de la valeur courante d'entrée lorsque le signal reçu est modulé. On doit donc choisir k suffisamment petit pour éviter que les ondulations du signal de sortie du moyenneur 3 ne provoque des commutations intempestives des comparateurs C1 ou C2. Les valeurs des seuils DETH et LOSSTH des comparateurs C1 et C2 sont généralement choisies à l'intérieur de la fourchette séparant les seuils fixés par la norme (-43 dBm et -48 dBm pour la norme V27) en étant distantes l'une de l'autre d'une valeur supérieure à la valeur de l'hystérésis requise (soit >2 dB pour la norme V27). Par exemple pour la norme V27, le seuil de détection DETH est fixé à -44 dBm et le seuil de perte LOSSTH est fixé à -47 dBm.

De surcroît, plus le débit du signal modulé est élevé, plus le facteur de crête du signal reçu augmente et plus l'amplitude des ondulations du signal de sortie du moyenneur 3 augmente. Ceci conduit à ce que plus le débit augmente, plus le coefficient k doit être faible. Le respect de cette dernière condition, en présence d'un signal modulé avec un débit de 2400 bits par seconde, conduirait pour la norme V27 à prendre pour k la valeur de 0,002. Cela entraînerait une constante de temps, ou temps de réponse, du filtre de 240 ms, au lieu des 15 ms maximum exigées. Ce phénomène est encore plus important dans le cas d'une modulation QAM (par exemple selon la norme V17) que dans le cas d'une modulation DPH (par exemple selon la norme V27).

Le compromis que l'on est alors contraint de faire, conduit à ce que les détecteurs classiques ne respectent les conditions spécifiées qu'avec une porteuse pure, c'est-à-dire non modulée. Ainsi on privilégie la constante de temps du filtre pour respecter la contrainte de délai de commutation au détriment de la précision du filtre en présence d'un signal modulé.

L'invention vise à éviter ce compromis en proposant un détecteur de présence d'une transmission qui permette de respecter à la fois les contraintes de délai de commutation et de précision du détecteur, même en fonctionnement normal du modem, c'est-à-dire avec un signal modulé.

Pour atteindre cet objet, la présente invention prévoit un détecteur de présence d'une transmission dans un modem, comportant un circuit de détermination de valeur absolue d'un signal reçu, un premier moyenneur de cette valeur absolue dont la sortie est reliée à l'entrée de deux premiers comparateurs ayant respectivement un seuil de comparaison prédéterminé de détection d'une transmission et un seuil prédéterminé de comparaison de perte d'une transmission, un second moyenneur de cette valeur absolue dont la sortie est reliée à l'entrée de deux seconds comparateurs ayant chacun un seuil de comparaison extrême prédéterminé, lesdits seuils de comparaison extrêmes encadrant les deux seuils de détection et de perte, ledit premier moyenneur possédant une constante de temps de l'ordre de 10 à 30 fois supérieure à la constante de temps du second moyenneur, et le détecteur comportant en outre un moyen pour délivrer un signal de détection sur la base des résultats issus des quatre comparateurs.

Selon un mode de réalisation de l'invention, le détecteur comporte une machine d'état délivrant un signal de détection à deux états sur la base des résultats issus des quatre comparateurs, chaque comparateur desdits deux seconds comparateurs étant prioritaire devant le premier comparateur dont le seuil de détection ou de perte lui est le plus proche.

Selon un mode de réalisation de l'invention, chaque moyenneur est constitué d'un intégrateur, dont une première entrée reçoit la valeur absolue courante du signal reçu affectée d'un coefficient inférieur à l'unité, et dont une seconde entrée reçoit la valeur de sortie précédente de l'intégrateur affectée d'un coefficient représentant la différence entre l'unité et le coefficient affecté à la première entrée.

Selon un mode de réalisation de l'invention, chaque seuil extrême est distant du seuil de détection ou de perte qui lui est le plus proche, d'une valeur représentant au moins la différence entre les amplitudes des ondulations du second moyenneur et des ondulations du premier moyenneur, en présence d'un signal reçu modulé.

Selon un mode de réalisation de l'invention, la constante de temps du premier moyenneur est comprise entre 100 et 300 ms, et la constante de temps du second moyenneur est comprise entre 5 et 15 ms.

Selon un mode de réalisation de l'invention, l'intervalle entre les valeurs des seuils de détection et de perte des deux premiers comparateurs est supérieur à 2 dB.

Ces objets, caractéristiques et avantages, ainsi que d'autres de la présente invention seront exposés en détail dans la description suivante de modes de réalisation particuliers faite à titre non limitatif en relation avec les figures jointes parmi lesquelles :
la figure 1 décrite précédemment est destinée à exposer l'état de la technique et le problème posé ;
la figure 2 représente schématiquement un mode de réalisation d'un détecteur de présence d'une transmission selon l'invention ;
la figure 3 représente un organigramme illustrant le fonctionnement d'un mode de réalisation d'un détecteur selon l'invention ; et
les figures 4A et 4B illustrent, sous forme de chronogrammes, la forme des principaux signaux d'un mode de réalisation d'un détecteur selon l'invention.

Comme le montre la figure 2, un détecteur selon l'invention se caractérise par la présence de deux moyenneurs 13 et 19 associés chacun à deux comparateurs, respectivement C3, C4 et C5, C6. Un premier moyenneur 19 est dimensionné pour être très précis, c'est-à-dire avec une constante de temps importante, et est associé à deux premiers comparateurs C5 et C6 dont les seuils correspondent aux seuils de détection DETH et de perte LOSSTH usuels. Un second moyenneur 13 est dimensionné pour être rapide, c'est-à-dire avec une faible constante de temps, et est associé à deux seconds comparateurs C3 et C4 dont les seuils DETHF et LOSSTHF correspondent à des valeurs extrêmes choisies au-delà des valeurs requises par la norme.

Ainsi, on effectue une comparaison rapide sur des valeurs extrêmes de seuils DETHF et LOSSTHF qui encadrent les seuils de détection DETH et de perte LOSSTH dans la mesure où si ces seuils extrêmes sont atteints, on est sûr d'être dans la situation correspondante. Par contre, entre ces deux valeurs extrêmes DETHF et LOSSTHF, on effectue une comparaison plus lente par rapport aux seuils de détection DETH et de perte LOSSTH.

Les sorties des comparateurs C5, C6, C3 et C4 sont envoyées à une machine d'état 4' chargée de délivrer, comme précédemment, un signal de détection OUT à deux états ON et OFF. Les deux moyenneurs 13 et 19 reçoivent la valeur absolue du signal reçu Rx délivrée par un circuit de détermination de valeur absolue 12. On peut prévoir d'utiliser un seul circuit de détermination de valeur absolue 12 dont la sortie est envoyée sur les entrées de chaque moyenneur 13 et 19, ou d'utiliser un circuit de détermination de valeur absolue pour chaque moyenneur 13 et 19.

Les moyenneurs 13 et 19 sont comme précédemment constitués d'un intégrateur associé à deux multiplieurs, chaque moyenneur 13 ou 19 présentant respectivement un coefficient k ou k' fixant sa constante de temps.

L'écart entre chaque seuil extrême, respectivement DETHF et LOSSTHF, et le seuil, respectivement de détection DETH et de perte LOSSTH, qui lui est le plus proche est déterminé par la différence entre l'amplitude crête maximale des ondulations du moyenneur rapide 13 et l'amplitude crête maximale des ondulations du moyenneur lent 19. Ceci afin d'éviter d'introduire une indécision dans la détection, sous l'effet d'un chevauchement des ondulations des moyenneurs 13 et 19.

Le dimensionnement des moyenneurs 13 et 19 et la détermination des valeurs des seuils des comparateurs C5, C6, C3, C4, s'effectue sur la base de ces contraintes de fonctionnement et des contraintes fixées par la norme.

La figure 3 illustre sous forme d'organigramme, un exemple de mode de fonctionnement du détecteur selon l'invention, qui permet de déterminer les caractéristiques de la machine d'état 4' de façon à obtenir le signal de détection OUT. On a supposé pour l'établissement de cette figure que tous les comparateurs C5, C6, C3, C4 présentaient un état de sortie haut (1) lorsque leur entrée positive dépasse le seuil envoyé sur leur entrée négative, et un état de sortie bas (0) dans le cas contraire.

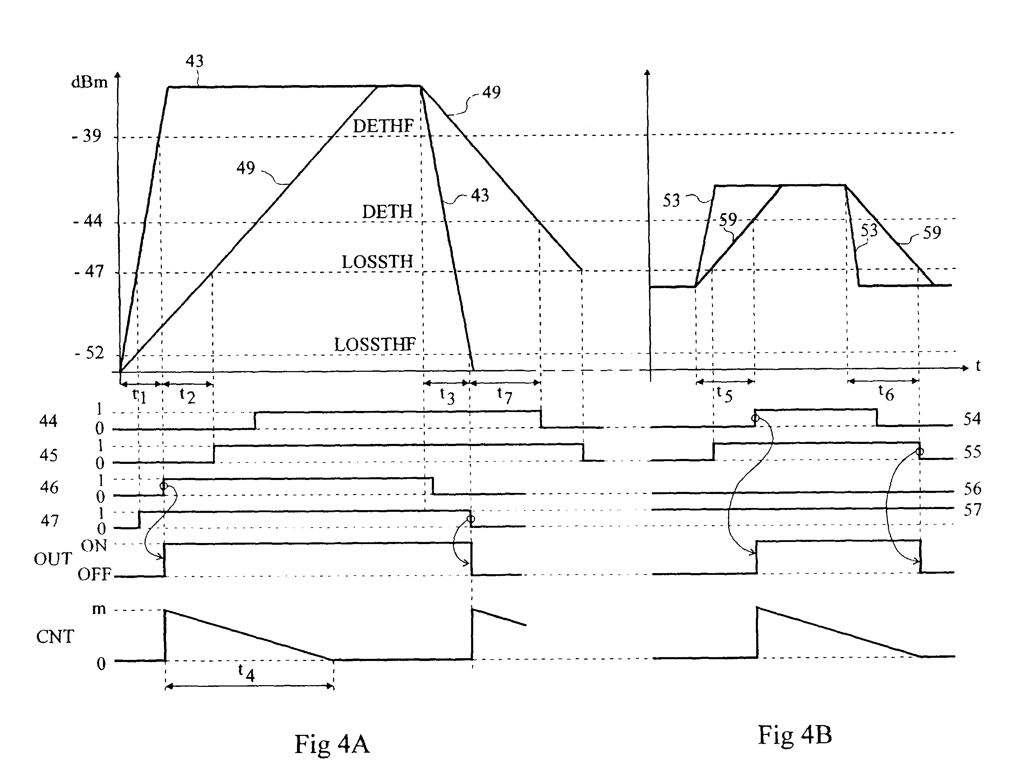

Un compteur CNT est décrémenté à chaque début de cycle. Ce compteur est initialisé à une valeur m donnée (par exemple 1000) à chaque fois que l'état du signal de détection OUT change. Le rôle de ce compteur est d'éviter que le signal de détection OUT oscille entre ses deux états ON et OFF pendant que le moyenneur lent 19 se stabilise suite à une commutation déclenchée par les comparateurs C3 ou C4 associés au moyenneur rapide 13. Ce rôle sera mieux compris en relation avec les figures 4A et 4B.

Au début (START) de chaque cycle, le compteur CNT est décrémenté de 1 et un premier test est effectué dans la machine d'état 4' en fonction de l'état précédent du signal de détection OUT.

En supposant qu'à la fin (END) du cycle précédent, le signal de détection OUT était dans son état OFF indiquant une absence de transmission, on examine la sortie du comparateur C3.

Si la sortie de ce comparateur C3 indique un dépassement du seuil DETHF, c'est-à-dire que l'énergie du signal reçu Rx est supérieure au seuil DETHF, on considère qu'une transmission est présente. Le signal de détection OUT est alors positionné dans son état ON et le compteur CNT est réinitialisé à la valeur m.

Si par contre l'énergie du signal reçu Rx est inférieure au seuil DETHF, on examine alors l'état du compteur CNT. Si le compteur n'est pas inférieur ou égal à 0, c'est-à-dire si le nombre de cycles effectués depuis la dernière commutation du signal de détection OUT est inférieur à la valeur m, le signal de détection est maintenu dans son état OFF. Si le compteur est inférieur ou égal à 0, c'est-à-dire si l'état du signal de détection n'a pas changé depuis m cycles, on examine la sortie du comparateur C5. Si cette sortie indique un dépassement du seuil DETH, c'est-à-dire que l'énergie du signal reçu Rx est supérieure au seuil de détection DETH, on positionne le signal de détection OUT dans son état ON et on réinitialise le compteur CNT à la valeur m. Dans le cas contraire, le signal de détection OUT est maintenu dans son état OFF.

En supposant maintenant que lors du cycle précédent, le signal de détection OUT était dans son état ON indiquant la présence d'une transmission, on examine la sortie du comparateur C4.

Si la sortie de ce comparateur C4 indique un dépassement du seuil LOSSTHF, c'est-à-dire que l'énergie du signal reçu Rx est inférieure au seuil LOSSTHF, on considère que la transmission a disparu. Le signal de détection OUT est alors positionné dans son état OFF et le compteur CNT est réinitialisé à la valeur m.

Si par contre l'énergie du signal reçu Rx est supérieure au seuil LOSSTHF, on examine alors l'état du compteur CNT. Si le compteur n'est pas à 0, c'est-à-dire si le nombre de cycles effectués depuis la dernière commutation du signal de détection OUT est inférieur à la valeur m, le signal de détection est maintenu dans son état ON. Si le compteur est inférieur ou égal à 0, c'est-à-dire si l'état du signal de détection n'a pas changé depuis m cycles, on examine la sortie du comparateur C6. Si cette sortie indique un dépassement du seuil LOSSTH, c'est-à-dire que l'énergie du signal reçu Rx est inférieure au seuil de perte LOSSTH, on positionne le signal de détection OUT dans son état OFF et on réinitialise le compteur CNT à la valeur m. Dans le cas contraire, le signal de détection OUT est maintenu dans son état ON.

On voit donc que l'on commence toujours par examiner le résultat de la comparaison de la sortie du moyenneur rapide 13 avec les seuils extrêmes DETHF et LOSSTHF afin d'autoriser en cas de dépassement de ces seuils une commutation immédiate du signal de détection. La sortie du moyenneur lent 19 n'est utilisée que lorsque l'énergie du signal reçu est comprise entre les deux seuils extrêmes DETHF et LOSSTHF. De fortes ondulations de sortie du moyenneur rapide 13 ne sont dans ce cas pas gênantes dans la mesure où les seuils extrêmes DETHF et LOSSTHF sont fixés pour que les ondulations du moyenneur rapide 13 ne chevauchent pas les ondulations du moyenneur lent 19. En d'autres termes, les changements d'état des comparateurs C3 et C4 sont respectivement prioritaires devant les comparateurs C5 et C6. De plus, l'état du comparateur C5 ou C6 n'est pris en compte que si le signal de détection est dans le même état depuis un nombre de cycles donné. On obtient ainsi une détection à la fois fiable et rapide de la présence d'une transmission.

Par exemple, on fixe la constante de temps du moyenneur lent 19, en fonction du débit de transmission, pour que l'amplitude crête maximale de ses ondulations n'excède pas l'hystérésis requise par la norme (2 dB pour la norme V27). Les valeurs des seuils de détection DETH et de perte LOSSTH sont choisies classiquement selon cette hystérésis en étant respectivement inférieure et supérieure aux valeurs fixées par la norme (par exemple -43 dBm et -48 dBm pour la norme V27). En d'autres termes, les valeurs des seuils de détection DETH et de perte LOSSTH (par exemple -44 dBm et -47 dBm pour la norme V27) sont choisies pour qu'avec un niveau de signal reçu correspondant à la moyenne des deux seuils (par exemple -44,5 dBm), l'écart entre le niveau maximal des ondulations du moyenneur lent 19 et chacun des seuils DETH et LOSSTH corresponde au moins à la moitié de l'hystérésis requise par la norme.

Puis, on fixe la constante de temps du moyenneur rapide 13 pour respecter le délai de détection fixé par la norme (5 à 15 ms pour la norme V27). On peut alors en déduire l'amplitude crête maximale des ondulations de ce moyenneur rapide 13 en fonction du débit de transmission. Ce qui permet de déterminer les valeurs des seuils extrêmes DETHF et LOSSTHF. Ces valeurs des seuils extrêmes DETHF et LOSSTHF sont choisies de la même manière que les valeurs des seuils de détection DETH et de perte LOSSTH. En d'autres termes, les valeurs des seuils extrêmes DETHF et LOSSTHF (par exemple -39 dBm et -52 dBm) sont choisies pour qu'avec un niveau de signal reçu correspondant à la moyenne des deux seuils (par exemple -44,5 dBm), l'écart entre le niveau maximal des ondulations du moyenneur rapide 13 et chacun des seuils DETHF et LOSSTHF corresponde au moins à la moitié de l'hystérésis requise par la norme.

L'application de ces règles conduit à ce que le rapport entre les constantes de temps des moyenneurs 19 et 13 est par exemple compris entre 10 et 30.

Dans un exemple pratique de réalisation, appliqué à la norme V27 et pour un débit de 2400 bits par seconde, la valeur des coefficients k et k' des moyenneurs 13 et 19 est respectivement de l'ordre de 0,05 et de 0,002. Les moyenneurs possèdent ainsi respectivement une constante de temps de l'ordre de 10 ms et de 200 ms. Les valeurs des seuils des comparateurs C3, C5, C6, C4 sont par exemple respectivement de -39 dBm, -44 dBm, -47 dBm et - 52 dBm. La valeur m d'initialisation du compteur CNT, fixée en fonction de la constante de temps du moyenneur lent 19, est 1000.

Les figures 4A et 4B illustrent sous forme de chronogrammes le fonctionnement d'un tel détecteur selon l'invention. Ces figures indiquent la forme des signaux de sortie des moyenneurs 13 et 19, la forme des signaux de sortie des comparateurs C5, C6, C3 et C4, la forme du signal de décision OUT délivré par la machine d'état 4' et l'évolution du compteur CNT. La figure 4A illustre les commutations sous l'effet d'un dépassement des seuils DETHF et LOSSTHF associés au moyenneur rapide 13. La figure 4B illustre les commutations dues au moyenneur lent 19 entre les seuils DETHF et LOSSTHF. Pour des raisons de clarté du dessin, le signal sinusoïdal Rx reçu ainsi que le signal en sortie du circuit de détermination de valeur absolue 12 n'ont pas été représentés. De même, les échelles n'ont pas été respectées pour des raisons de clarté. En particulier, la différence entre les pentes des moyenneurs 13 et 19 est en pratique plus importante. Le chronogramme du signal de détection OUT tel que représenté aux figures 4A et 4B est conforme à l'organigramme de la figure 3.

En supposant (figure 4A) que la valeur absolue du signal reçu passe brutalement d'un niveau inférieur au seuil LOSSTHF à un niveau supérieur au seuil DETHF, la sortie du moyenneur rapide 13 atteint le seuil DETHF en un temps t1. Le comparateur C3 provoque alors la commutation du signal de détection OUT vers son état ON et le compteur CNT est initialisé à la valeur m. Tant que le compteur n'atteint pas la valeur 0, la sortie du comparateur C6 n'est pas prise en compte et le signal de détection OUT reste dans son état ON, pourvu que la sortie du moyenneur rapide 13 reste supérieure au seuil LOSSTHF du comparateur C4.

On remarque bien ici le rôle du compteur CNT. En effet, en l'absence de compteur, on examinerait les sorties du comparateur C6 dès que le signal de détection serait dans son état ON. Comme le comparateur C6 est associé au moyenneur lent 19, sa sortie ne peut avoir déjà commuté au moment où le signal de détection OUT passe dans son état ON. En conséquence, le signal de détection OUT oscillerait entre ses états ON et OFF pendant un temps t2, c'est-à-dire jusqu'à ce que la sortie du moyenneur lent 19 ait atteint le seuil LOSSTH de commutation du comparateur C6.

Le même raisonnement s'applique aux comparateurs C4 et C6 lorsque le niveau de sortie du circuit de détermination de valeur absolue redescend brusquement jusqu'à un niveau inférieur au seuil LOSSTHF. La sortie du moyenneur rapide 13 atteint le seuil LOSSTHF en un temps t3. Le comparateur C4 provoque alors la commutation du signal de détection OUT vers son état OFF et le compteur CNT est réinitialisé à la valeur m.

La valeur m d'initialisation du compteur CNT est choisie pour que le temps t4 qu'il met à être décrémenté jusqu'à 0 soit supérieur au temps t2 ou t7 nécessaire au moyenneur lent 19 pour atteindre respectivement l'un des seuils LOSSTH ou DETH suite à une commutation du comparateur C3 ou C4.

Les temps t1 et t3 sont liés à la constante de temps du moyenneur rapide 13 et fixent ici les délais de commutation du détecteur.

On suppose maintenant (figure 4B) que la valeur absolue du signal reçu est à un niveau compris entre les seuils LOSSTHF et LOSSTH et passe à un niveau compris entre les seuils DETH et DETHF. Les sorties des comparateurs C3 et C4 sont respectivement à 0 et 1 et ne sont donc pas prises en compte. Au bout d'un temps t5, la sortie du moyenneur lent 19 atteint le seuil DETH. Le comparateur C5 provoque alors la commutation du signal de détection OUT vers son état ON et le compteur CNT est réinitialisé à la valeur m. Tant que le compteur n'atteint pas la valeur 0, la sortie du comparateur C6 n'est pas prise en compte et le signal de détection OUT reste dans son état ON.

Le même raisonnement s'applique au comparateur C6 lorsque le niveau de sortie du circuit de détermination de valeur absolue redescend jusqu'à un niveau inférieur au seuil LOSSTH. La sortie du moyenneur lent 19 atteint le seuil LOSSTH en un temps t6. Le comparateur C6 provoque alors la commutation du signal de détection OUT vers son état OFF et le compteur CNT est réinitialisé à la valeur m.

Les temps t5 et t6 sont liés à la constante de temps du moyenneur lent 19 et fixent ici les délais de commutation du détecteur.

Dans un cas de figure tel que représenté à la figure 4B, la présence du compteur CNT n'est cependant pas indispensable. En effet, on examine ici que les commutations liées au moyenneur lent 19. En d'autres termes, une fois que le compteur CNT a atteint la valeur 0 suite à une commutation du signal de détection OUT déclenchée par un des comparateurs extrêmes C3 ou C4, le compteur CNT peut n'être réinitialisé que lors d'une nouvelle commutation liée à un de ces comparateurs extrêmes C3 ou C4.

Bien entendu, la présente invention est susceptible de diverses variantes et modifications qui apparaîtront à l'homme de l'art. En particulier, chacun des composants décrits pourra être remplacé par un ou plusieurs éléments remplissant la même fonction.

De plus, alors que certaines des explications précédentes ont été données par soucis de clarté en utilisant un vocabulaire qui correspond parfois à un fonctionnement analogique, il sera clair pour l'homme du métier que tous les éléments du circuit selon la présente invention traitent des signaux numériques et que les constituants du circuit illustrés sous forme matérielle pourront correspondre en pratique à des réalisations logicielles.

## Revendications

1. Détecteur de présence d'une transmission dans un modem, comportant un circuit de détermination de valeur absolue (12) d'un signal reçu (Rx), un premier moyenneur (19) de cette valeur absolue dont la sortie est reliée à l'entrée de deux premiers comparateurs (C5, C6) ayant respectivement un seuil de comparaison prédéterminé de détection d'une transmission (DETH) et un seuil prédéterminé de comparaison de perte (LOSSTH) d'une transmission, caractérisé en ce qu'il comporte en outre un second moyenneur (13) de cette valeur absolue dont la sortie est reliée à l'entrée de deux seconds comparateurs (C3, C4) ayant chacun un seuil de comparaison extrême (DETHF, LOSSTHF) prédéterminé, lesdits seuils de comparaison extrêmes encadrant les deux seuils de détection (DETH) et de perte (LOSSTH), en ce que ledit premier moyenneur (19) possède une constante de temps de l'ordre de 10 à 30 fois supérieure à la constante de temps du second moyenneur (13), et en ce que le détecteur comporte un moyen (4') pour délivrer un signal de détection (OUT) sur la base des résultats issus des quatre comparateurs (C5, C6, C3, C4).

2. Détecteur de présence d'une transmission dans un modem selon la revendication 1, caractérisé en ce qu'il comporte une machine d'état (4') délivrant un signal de détection (OUT) à deux états (ON, OFF) sur la base des résultats issus des quatre comparateurs (C5, C6, C3, C4), chaque comparateur desdits deux seconds comparateurs (C3, C4) étant prioritaire devant le premier comparateur (C5, C6) dont le seuil de détection (DETH) ou de perte (LOSSTH) lui est le plus proche.

3. Détecteur de présence d'une transmission dans un modem selon la revendication 1 ou 2, caractérisé en ce que chaque moyenneur (13, 19) est constitué d'un intégrateur, dont une première entrée reçoit la valeur absolue courante du signal reçu (Rx) affectée d'un coefficient (k) inférieur à l'unité, et dont une seconde entrée reçoit la valeur de sortie précédente de l'intégrateur affectée d'un coefficient (1-k) représentant la différence entre l'unité et le coefficient (k) affecté à la première entrée.

4. Détecteur de présence d'une transmission dans un modem selon l'une quelconque des revendications 1 à 3, caractérisé en ce que chaque seuil extrême (DETHF, LOSSTHF) est distant du seuil de détection (DETH) ou de perte (LOSSTH) qui lui est le plus proche, d'une valeur représentant au moins la différence entre les amplitudes des ondulations du second moyenneur (13) et des ondulations du premier moyenneur (19), en présence d'un signal reçu (Rx) modulé.

5. Détecteur de présence d'une transmission dans un modem selon l'une quelconque des revendications 1 à 4, caractérisé en ce la constante de temps du premier moyenneur (19) est comprise entre 100 et 300 ms, et en ce que la constante de temps du second moyenneur (13) est comprise entre 5 et 15 ms.

6. Détecteur de présence d'une transmission dans un modem selon la revendication 5, caractérisé en ce que l'intervalle entre les valeurs des seuils de détection (DETH) et de perte (LOSSTH) des deux premiers comparateurs (C5, C6) est supérieur à 2 dB.

## Patentansprüche

1. Detektor für das Vorliegen einer Übertragung in einem Modem, wobei das Modem umfaßt eine Schaltung (12) zur Bestimmung des Absolutwerts eines Empfangssignals (Rx), einen ersten Mittelwertbildner (19) für diesen Absolutwert, dessen Ausgang mit dem Eingang von zwei ersten Komparatoren (C5, C6) verbunden ist, welche jeweils einen vorgegebenen Vergleichsschwellwert für den Nachweis bzw. die Detektion einer Übertragung (DETH) und einen vorgegebenen Vergleichsschwellwert für den Verlust (LOSSTH) einer Übertragung aufweisen,
dadurch gekennzeichnet, daß der Detektor des weiteren einen zweiten Mittelwertbildner (13) für diesen Absolutwert aufweist, dessen Ausgang mit dem Eingang von zwei zweiten Komparatoren (C3, C4) verbunden ist, die jeweils einen vorgegebenen extremen Vergleichsschwellwert (DETHF, LOSSTHF) aufweisen, wobei die genannten extremen Vergleichsschwellwerte die beiden Detektions(DETH)- und Verlust(LOSSTH)-Schwellwerte einschließen, daß der genannte erste Mittelwertbildner (19) eine Zeitkonstante in der Größenordnung des 10- bis 30-fachen der Zeitkonstante des zweiten Mittelwertbildners (13) besitzt, und daß der Detektor eine Vorrichtung (4') zur Abgabe eines Detektionssignals (OUT) auf der Grundlage der Ergebnisse der vier Komparatoren (C5, C6, C3, C4) aufweist.

2. Detektor für das Vorliegen einer Übertragung in einem Modem gemäß Anspruch 1,
dadurch gekennzeichnet, daß der Detektor eine Zustandsvorrichtung (4') aufweist, welche ein Detektionssignal (OUT) mit zwei Zuständen (EIN, AUS) auf der Grundlage der von den vier Komparatoren (C5, C6, C3, C4) gelieferten Ergebnisse abgibt, wobei jeweils jeder der beiden genannten zweiten Komparatoren (C3, C4) Vorrang vor dem ersten Komparator (C5, C6) besitzt, dessen Detektionsschwellwert (DETH) oder dessen Verlustschwellwert (LOSSTH) ihm am nächsten ist.

3. Detektor für das vorliegen einer Übertragung in einem Modem nach den Ansprüchen 1 oder 2,
dadurch gekennzeichnet, daß jeweils jeder Mittelwertbildner (13, 19) aus einem Integrator besteht, der an einem ersten Eingang den mit einem Koeffizienten (k) kleiner als Eins versehenen laufenden Absolutwert des Empfangssignals (Rx) zugeführt erhält, und der an einem zweiten Eingang den vorhergehenden Ausgangswert des Integrators zugeführt erhält, der mit einem Koeffizienten (1-k) versehen ist, welcher die Differenz zwischen Eins und dem an dem ersten Eingang angewendeten Koeffizienten (k) wiedergibt.

4. Detektor für das Vorliegen einer Übertragung in einem Modem gemäß einem der Ansprüche 1 bis 3,
dadurch gekennzeichnet, daß jeweils jeder extreme Schwellwert (DETHF, LOSSTHF) von dem ihm nächsten Detektionsschwellwert (DETH) oder Verlustschwellwert (LOSSTH) um einen Abstand entfernt ist, dessen Größe wenigstens die Differenz zwischen den Amplituden der Welligkeit des zweiten Mittelwertbildners (13) und der Welligkeit des ersten Mittelwertbildners (19) in Gegenwart eines modulierten Empfangssignals (Rx) wiedergibt.

5. Detektor für das Vorliegen einer Übertragung in einem Modem gemäß einem der Ansprüche 1 bis 4,
dadurch gekennzeichnet, daß die Zeitkonstante des ersten Mittelwertbildners (19) zwischen 100 und 300 ms liegt und daß die Zeitkonstante des zweiten Mittelwertbildners (13) zwischen 5 und 15 ms liegt.

6. Detektor für das Vorliegen einer Übertragung in einem Modem nach Anspruch 5,
dadurch gekennzeichnet, daß das Intervall bzw. der Abstand zwischen den Beträgen der Detektionsschwellwerte (DETH) und der Verlustschwellwerte (LOSSTH) der beiden ersten Komparatoren (C5, C6) größer als 2 dB ist.

## Claims

1. A detector of the presence of a transmission in a modem, comprising a circuit for determining the absolute value (12) of a receive signal (Rx), a first averaging block (19) of said absolute value, the output of which is connected to the input of two first comparators (C5, C6), respectively having a predetermined comparison threshold for detecting a transmission (DETH) and a predetermined comparison threshold of a transmission loss (LOSSTH), characterized in that it further comprises a second averaging block (13) of said absolute value, the output of which is connected to two second comparators (C3, C4), each having an extreme predetermined threshold (DETHF, LOSSTHF), said two detection (DETH) and loss (LOSSTH) thresholds being within said two extreme thresholds, in that the time constant of the first averaging block (19) is about 10 or 30 times greater than that of the second averaging block (13) and in that the detector comprises means (4') for providing a detection signal (OUT), based on the results from the four comparators (C5, C6, C3, C4).

2. A detector of the presence of a transmission in a modem according to claim 1, characterized in that it includes a state machine (4') issuing a detection signal (OUT) with two states (ON, OFF) based on the results coming from the four comparators (C5, C6, C3, C4), each extreme comparator (C3, C4) having priority over the first comparator (C5, C6) having the closest detection (DETH) or loss (LOSSTH) threshold.

3. A detector of the presence of a transmission in a modem according to claim 1 or 2, characterized in that each averaging block (13, 19) is constituted by an integrator, a first input of which receives the current absolute value of the receive signal (Rx) assigned with a coefficient (k) smaller than 1, and a second input of which receives the previous output value of the integrator assigned with a coefficient (1-k) representing the difference between 1 and the coefficient (k) assigned to the first input.

4. A detector of the presence of a transmission in a modem according to any of claims 1 to 3, characterized in that the distance between each extreme threshold (DETHF, LOSSTHF) and the closest detection (DETH) or loss (LOSSTH) threshold has a value representing at least the difference between the amplitudes of the ripple of the second averaging block (13) and of the ripple of the first averaging block (19), in presence of a modulated receive signal (Rx).

5. A detector of the presence of a transmission in a modem according to any of claims 1 to 4, characterized in that the time constant of the first averaging block (19) is included between 100 and 300 ms, and wherein the time constant of the second averaging block (13) is included between 5 and 15 ms.

6. A detector of the presence of a transmission in a modem according to claim 5, characterized in that the interval between the values of the detection (DETH) and loss (LOSSTH) thresholds of the first two comparators (C5, C6) is greater than 2 dB.
